(19) Europäisches Patentamt
European Patent Office
Office européen des brevets

(11) EP 1 715 728 A1

(12) **EUROPEAN PATENT APPLICATION**
published in accordance with Art. 158(3) EPC

(43) Date of publication:
**25.10.2006 Bulletin 2006/43**

(21) Application number: **05709677.8**

(22) Date of filing: **03.02.2005**

(51) Int Cl.:
***H05B 33/14*** *(2006.01)* ***H05B 33/22*** *(2006.01)*

(86) International application number:
**PCT/JP2005/001584**

(87) International publication number:
**WO 2005/076668 (18.08.2005 Gazette 2005/33)**

(84) Designated Contracting States:
**BE DE FR GB NL**

(30) Priority: **06.02.2004 JP 2004030291**

(71) Applicant: **IDEMITSU KOSAN CO., LTD.**
**Tokyo 100-8321 (JP)**

(72) Inventors:
- **MATSUURA, Masahide**
  **2990293 (JP)**
- **IWAKUMA, Toshihiro**
  **2990293 (JP)**
- **YAMAMICHI, Keiko**
  **2990293 (JP)**
- **HOSOKAWA, Chishio**
  **2990293 (JP)**

(74) Representative: **Gille Hrabal Struck Neidlein Prop Roos**
**Patentanwälte**
**Brucknerstrasse 20**
**40593 Düsseldorf (DE)**

(54) **ORGANIC ELECTROLUMINESCENT DEVICE**

(57) An organic electroluminescent device having a structure in which an emitting layer (3) containing an organic metal complex having at least a heavy metal as a central metal and an electron-transporting layer (4) are stacked between an anode (2) and a cathode (1), wherein a difference ($\Delta AF$) in electron affinity between a main organic material forming the emitting layer (3) and a main material forming the electron-transporting layer (4) satisfies the following expression; "$0.2\ eV < \Delta AF \leq 0.65\ eV$".

FIG. 1

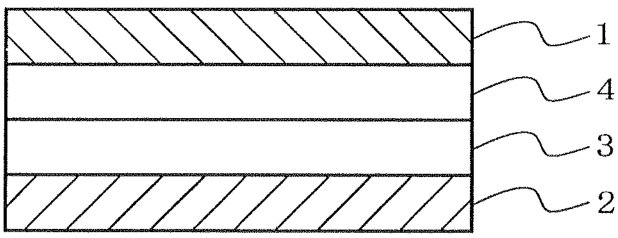


EP 1 715 728 A1

## Description

TECHNICAL FIELD

The invention relates to an organic electroluminescent device (hereinafter abbreviated as "organic EL device"). In particular, the invention relates to a highly efficient organic EL device.

BACKGROUND ART

An organic EL device using an organic substance is a promising solid-state emitting type inexpensive and large full-color display device, and has been extensively developed. An EL device generally includes an emitting layer and a pair of opposing electrodes holding the emitting layer therebetween. In the EL device, electrons and holes are injected into the emitting layer respectively from a cathode and an anode upon application of an electric field between the electrodes. The electrons and the holes recombine in the emitting layer to produce an excited state, and the energy is emitted as light when the excited state returns to the ground state. The EL device emits light by utilizing this phenomenon.

Various configurations have been known as the configuration of the organic EL device. For example, use of an aromatic tertiary amine as a material for a hole-transporting layer has been disclosed for an organic EL device having the device configuration of "indium tin oxide (ITO)/hole-transporting layer/emitting layer/cathode" (see JP-A-63-295695). This device configuration achieves a high luminance of several hundreds $cd/m^2$ at an applied voltage of 20 V or less.

It has been reported that a luminous efficiency of about 40 lm/W or more is achieved at a luminance equal to or less than several hundreds $cd/m^2$ by using an iridium complex (phosphorescent dopant) as a dopant for an emitting layer (see Tsutsui et al., "Japanese Journal of Applied Physics", Vol. 38 (1999), p. 1502-1504).

However, since most phosphorescent organic EL devices emit green light, a multi-color device has been demanded. Moreover, an increase in the current efficiency of the device has also been demanded.

DISCLOSURE OF THE INVENTION

The inventors have made various researches focusing on the above-mentioned problems in order to develop an organic EL device which has a higher current efficiency and emits light in a blue range, and found that reducing an energy difference between a material constituting an electron-transporting layer and an electron-transporting host material constituting an emitting layer to a certain level or less improves the electron-injecting efficiency to the emitting layer and then the carrier balance, whereby an organic EL device with a high current efficiency can be obtained. The inventors have found that the above-mentioned object is achieved by employing a device structure having energy characteristics represented by the following formula (1). The invention was completed based on the knowledge.

The invention provides the following organic EL device.

(1) An organic electroluminescent device having a structure in which at least an emitting layer and an electron-transporting layer are stacked between an anode and a cathode, the emitting layer containing an organic metal complex having at least a heavy metal as a central metal,

wherein a difference ($\Delta$AF) in electron affinity between a main organic material forming the emitting layer and a main material forming the electron-transporting layer satisfies the following expression; "$0.2 \text{ eV} < \Delta AF \leq 0.65 \text{ eV}$".

(2) The organic electroluminescent device according to (1) which emits electroluminescence at a longer wavelength than the wavelength corresponding to the triplet energy gap ($Eg^T$(Dopant)) of the organic metal complex having a heavy metal as a central metal.

(3) The organic electroluminescent device according to (1) or (2), wherein the electroluminescence at a longer wavelength than the wavelength corresponding to the triplet energy gap ($Eg^T$(Dopant)) of the organic metal complex having a heavy metal as a central metal is a main component of electroluminescence emitted from the device.

(4) The organic electroluminescent device according to any one of (1) to (3), wherein the main organic material forming the emitting layer has an electron transporting property.

(5) The organic electroluminescent device according to any one of (1) to (4), wherein the triplet energy gap ($Eg^T$ (Host)) of the main organic material forming the emitting layer is 2. 52 eV or more.

(6) The organic electroluminescent device according to any one of (1) to (5), wherein the triplet energy gap ($Eg^T$ (Dopant)) of the organic metal complex having a heavy metal as a central metal is equal to or greater than the triplet energy gap ($Eg^T$(ETL)) of the main material forming the electron-transporting layer.

(7) The organic electroluminescent device according to any one of (1) to (6), wherein the triplet energy gap ($Eg^T$ (Host)) of the main organic material forming the emitting layer is equal to or greater the triplet energy gap ($Eg^T$ (Dopant)) of the organic metal complex having a heavy metal as a central metal.

The invention provides a phosphorescent organic EL device, particularly emitting light in a blue region, which exhibits high current efficiency.

BRIEF DESCRIPTION OF THE DRAWINGS

FIG. 1 is a cross-sectional view showing an organic EL device according to one embodiment of the invention.
FIG. 2 is a view showing the emission spectrum of an organic EL device according to Example 1.
FIG. 3 is a view showing the emission spectrum of an organic EL device according to Example 8.

BEST MODE FOR CARRYING OUT THE INVENTION

The invention is described below in detail.
An organic EL device according to the invention has a structure in which at least an emitting layer and an electron-transporting layer are stacked between an anode and a cathode, the emitting layer containing an organic metal complex having at least a heavy metal as a central metal, wherein a difference (ΔAf) in electron affinity between a main organic material forming the emitting layer and a main material forming the electron-transporting layer satisfies the following expression.

$$0.2\ \text{eV} < \Delta Af \leq 0.65\ \text{eV}$$

As shown in FIG. 1, the organic EL device according to the invention has a multilayer structure in which a plurality of layers including at least an emitting layer 3 and an electron-transporting layer 4 are formed between a pair of electrodes (cathode 1 and anode 2), wherein an organic medium forming the emitting layer 3 includes an organic metal complex having a heavy metal as a central metal (hereinafter abbreviated as "heavy metal organic complex"), and the emitting layer 3 and the electron-transporting layer 4 are stacked.
The organic EL device according to the invention satisfies the condition shown by the following expression (1) to achieve a high current efficiency.

$$0.2\ \text{eV} < \Delta Af \leq 0.65\ \text{eV} \qquad (1)$$

In the expression (1), ΔAf indicates the difference between the electron affinity (Af (emitting layer)) of the main organic material forming the emitting layer and the electron affinity (Af (electron-transporting layer)) of the main material forming the electron-transporting layer (i.e. "ΔAf = Af (electron-transporting layer) - Af (emitting layer)").
The electron affinity Af (eV) of each material is determined from the difference between the ionization potential Ip (eV) and the optical energy gap Eg (eV) of the material.

$$Af = Ip - Eg$$

If the difference ΔAf is 0.2 eV or less, since storage of electrons at the interface between the electron-transporting layer and the emitting layer becomes insufficient due to the small electron barrier between the electron-transporting layer and the emitting layer, electrons are insufficiently accumulated in the emitting layer. This results in a decrease in recombination probability between electrons and holes in the emitting layer, whereby the luminous efficiency (particularly current efficiency) is insufficiently improved.
If the difference ΔAf is greater than 0.65 eV, since the difference between the electron affinity Af (emitting layer) of the main organic material forming the emitting layer and the electron affinity Af (electron-transporting layer) of the main material forming the electron-transporting layer is increased, the interaction between the molecules forming each layer tends to occur at the interface between the emitting layer and the electron-transporting layer. As a result, since the excitation energy due to recombination is consumed by such an interaction, the excitation energy is emitted as light at a reduced percentage, whereby the current efficiency is insufficiently improved.
In the organic EL device according to the invention, it is preferable that emission corresponding to the triplet energy gap of the heavy metal complex (phosphorescent dopant) be the major electroluminescent emission (hereinafter called "EL emission").
It is preferable that the electron affinity (Af (Dopant)) of at least one dopant (whether or not the dopant is luminescent) in the emitting layer be in a range between the electron affinity (Af (emitting layer)) of the main organic material forming the emitting layer and the electron affinity (Af (electron-transporting layer)) of the electron-transporting layer adjacent to the emitting layer.
In the organic EL device according to the invention, the main organic material forming the emitting layer (hereinafter abbreviated as "major emitting layer material") preferably has an electron transporting capability. If the major emitting layer material has an electron transporting capability, charges (particularly electrons) are not accumulated at the interface between the emitting layer and the electron-transporting layer, whereby the emission region in the emitting layer can be separated from the interface. This allows the excitation energy due to recombination between electrons and holes to be efficiently converted into emission from the dopant.
In order to convert the recombination excitation energy into dopant emission, it is preferable that the triplet energy gap ($Eg^T$ (Host)) of the major emitting layer material be 2.52 eV or more, preferably 2.75 eV or more, and still more preferably 2.8 eV or more. In order to obtain emission from the triplet state of the heavy metal organic complex as the dopant, it is preferable that the triplet energy gap ($Eg^T$ (Host)) of the major emitting layer material be greater than the triplet energy gap ($Eg^T$ (Dopant)) of the heavy metal organic complex. In particular, in order to obtain EL emission in the blue region using the triplet energy from the heavy metal organic complex, it is preferable that the triplet energy gap ($Eg^T$ (Host)) of the major emitting layer material be 2.8 eV or more.
It is preferable that the triplet energy gap ($Eg^T$ (Dopant)) of the heavy metal organic complex be equal to or greater than the triplet energy gap ($Eg^T$ (ETL)) of the material forming the electron-transporting layer. This configuration allows the recombination excitation energy occurring around the interface between the emitting layer and the electron-transporting layer to be efficiently transferred to the heavy metal organic complex dopant in the emitting layer with high probability rather than to the material forming the electron-transporting layer.
The ionization potential Ip of each material may be measured by applying light (excitation light) from a deuterium lamp to the material through a monochromator, measuring the resulting photoelectric emission using an electrometer, and calculating the photoelectric emission threshold value from the resulting photoelectric emission photon energy curve using an extrapolation method. The ionization potential Ip of each material may be measured using an atmosphere ultraviolet photoelectron spectrometer "AC-1" (manufactured by Riken Keiki Co., Ltd.) or the like.
The optical energy gap Eg of each material may be determined by applying light of which the wavelength was resolved to the material and converting the maximum wavelength of the absorption spectrum into the optical energy gap.
The triplet energy gap ($Eg^T$) of each organic material used in the invention is determined by the following method. The organic material used in the invention is measured by a known phosphorescence measurement method (e.g. method described in "The World of Photochemistry" (edited by The Chemical Society of Japan, 1993), page 50). In more detail, the organic material used in the invention is dissolved in a solvent (sample 10 micromol/L, EPA (diethyl ether:isopentane:ethanol = 5:5:2 (volume ratio)) to obtain a phosphorescence measurement sample. After placing the phosphorescence measurement sample in a quartz cell, the sample is cooled to 77°K. Excitation light is then applied to the sample, and the resulting phosphorescence is measured with respect to the wavelength. A tangent is drawn to the rise of the phosphorescence spectrum on the shorter wavelength side, and the value obtained by converting the wavelength into the energy value is taken as the triplet energy gap ($Eg^T$). The triplet energy gap ($Eg^T$) may be measured using a commercially available device "F-4500" (manufactured by Hitachi, Ltd.) or the like. The triplet energy gap ($Eg^T$) is converted using the following expression.

$$Eg^T\ (eV) = 1239.85/\lambda_{edge}$$

The meaning of "$\lambda_{edge}$" is as follows. A phosphorescence spectrum is expressed using the vertical axis as the phosphorescence intensity and the horizontal axis as the wavelength, and a tangent is drawn to the rise of the phosphorescence spectrum on the shorter wavelength side. In this case, "$\lambda_{edge}$" is the wavelength at the intersection of the tangent and the horizontal axis. The unit for "$\lambda_{edge}$" is nm.

As examples of the device configuration of the organic EL device according to the invention which satisfies the above conditions, the following configurations can be given. Note that the device configuration is not limited thereto.

(1) Anode/emitting layer/electron-transporting layer/cathode
(2) Anode/hole-transporting layer/emitting layer/electron-transporting layer/cathode
(3) Anode/hole-injecting layer/hole-transporting layer/emitting layer/electron-transporting layer/cathode

The elements may be stacked on a substrate in this order or in the reverse order.

Specific examples of the material compounds forming the organic EL device according to the invention are given below. Note that the materials used in the invention are not limited to the compounds given below. The objective organic EL device with a high current efficiency can be obtained as long as the above conditions are satisfied.

The major emitting layer material used in the organic EL device according to the invention is not particularly limited. Any material known as the material for the organic emitting layer may be used. As examples of the major emitting layer material, compounds exhibiting excellent thin film formability, such as amine derivatives, carbazole derivatives, oxadiazole derivatives, triazole derivatives, benzoxazole type, benzothiazole type, and benzimidazole type fluorescent whitening agents, metal chelate oxanoid compounds, and distyrylbenzene compounds, can be given. Of these, the carbazole derivatives are preferable.

In the organic EL device according to the invention, it is preferable that the triplet energy gap ($Eg^T$ (Host)) of the major emitting layer material be greater than the triplet energy gap ($Eg^T$ (Dopant)) of the heavy metal organic complex. This allows the energy of the major emitting layer material to be efficiently transferred to the heavy metal organic complex, whereby the luminous efficiency is improved.

The material forming the electron-transporting layer of the organic EL device according to the invention is not particularly limited. Any compound commonly used as the material for the electron-transporting layer may be used. As the material for the electron-transporting layer, organic metal complexes such as tris(8-quinolinolate)aluminum, tris(8-quinolinolate)gallium, and bis(10-benzo[h]quinolinolate)beryllium, oxadiazole derivatives, triazole derivatives, triazine derivatives, perylene derivatives, quinoline derivatives, quinoxaline derivatives, diphenylquinone derivatives, nitro-substituted fluorenone derivatives, thiopyrane dioxide derivatives, and the like can be given.

In the organic EL device according to the invention, the electron-transporting layer may have either a single layer configuration or a multilayer configuration. The electron-transporting layer may include a hole barrier layer formed of a material exhibiting hole barrier properties (function of confining holes in the emitting layer), that is, a material having an ionization potential greater than the ionization potential of the material forming the emitting layer.

As specific examples of the compound exhibiting hole barrier properties, phenanthroline derivatives and the like can be given.

The luminous efficiency can be further improved by adding an alkali metal, alkaline earth metal, rare earth metal, alkali compound, alkaline earth compound, rare earth compound, alkali metal to which an organic compound is coordinated, or the like to increase the electron injecting/transporting properties.

The heavy metal organic complex which is the dopant of the emitting layer used in the organic EL device according to the invention is not particularly limited. It is preferable to use a heavy metal organic complex functioning as a dopant which produces emission from the triplet excited state at room temperature.

It is preferable that the organic EL device according to the invention produce EL emission at a wavelength longer than the wavelength corresponding to the triplet energy gap ($Eg^T$ (Dopant)) of the heavy metal organic complex (EL emission of a long wavelength component). It is still more preferable that the EL emission of the long wavelength component be the major EL emission from the organic EL device.

The heavy metal organic complex used in the invention is not particularly limited. The heavy metal organic complex preferably has a triplet energy gap of 2.5 eV or more and 3.5 eV or less, and still more preferably 2. 6 eV or more. This aims at allowing the organic EL device to emit green to blue light. The invention is remarkably effective in this region.

It is preferable that the luminescent dopant function as a luminescent dopant which emits light from the triplet state at room temperature. As preferable examples of the heavy metal contained in the dopant, Ir, Pt, Pd, Ru, Rh, Mo, and Re can be given. As examples of the ligand to the heavy metal, a ligand which is coordinated or bonded to a metal

at C or N (CN ligand) and the like can be given. As specific examples of the ligand, the following compounds and substituted derivatives thereof can be given.

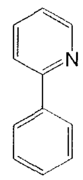
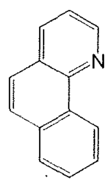
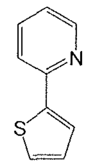
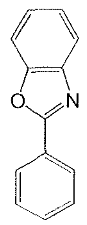
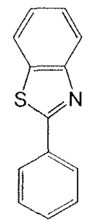
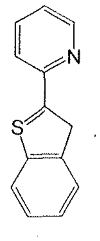
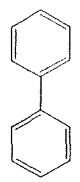
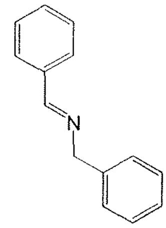

As examples of the substituent of the substituted derivatives, an alkyl group, alkoxy group, phenyl group, polyphenyl group, naphthyl group, fluoro (F) group, trifluoromethyl ($CF_3$) group, and the like can be given. As preferable examples of a blue light emitting ligand, the following compounds and the like can be given.

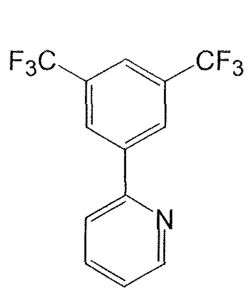
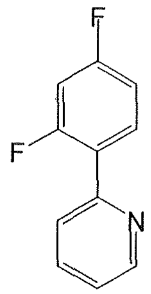
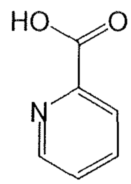

The concentration of a heavy metal organic complex added to an emitting layer is not particularly limited, but in view of current efficiency and driving voltage adjustment, the range from 0.1 to 20 mass% is preferable and the range from 1 to 15 mass% is more preferable.

In the organic EL device according to the invention, a hole-injecting layer, a hole-transporting layer, an electron-injecting layer, and the like may be provided, as required, in order to further increase the current (or luminous) efficiency. The materials for these layers are not particularly limited. A known organic material for an organic EL may be used.

In the invention, it is preferable to add an inorganic material to the hole-transporting layer and the electron-injecting layer to further improve a current efficiency. An inorganic material may be used as a charge injection auxiliary material for a hole-injecting layer or an electron-transporting layer. As the inorganic material, an inorganic semiconductor material is preferably used. Examples of the inorganic material include inorganic materials containing one or more elements selected from In, Sn, Ga, Si, Ge, Zn, Cd, Mg, Al, Ta and Ti, and chalcogenides and nitrides thereof.

The organic EL device according to the invention is preferably supported by a substrate. The material for the substrate is not particularly limited. A known material used for an organic EL device such as glass, transparent plastic,

or quartz may be used.

For an anode, metals, alloys, electrically conductive compounds or mixtures thereof which have a large work function (for example, 4.0 eV or more) are preferably used. Specifically metals such as Au and dielectric transparent materials such as CuI, ITO, $SnO_2$ and ZnO can be given.

The anode can be formed by forming the above materials into a thin film by vapor deposition, sputtering or the like. In the case where emission from the emitting layer is outcoupled through the anode, the transmittance of the anode is preferably more than 10%. The sheet resistance of the anode is preferably several hundreds Ω/□ or less. The film thickness of the anode, which is varied depending upon the material thereof, is usually from 10 nm to 1 μm, preferably from 10 to 200 nm.

For a cathode, metals, alloys, electrically conductive compounds or mixtures thereof which have a small work function (for example, 4.0 eV or less) are preferably used. Specifically aluminum, lithium, sodium, magnesium/silver mixture, magnesium/copper mixture, $Al/Al_2O_3$ and indium can be given as an example.

The cathode can be formed by forming the above materials into a thin film by vapor deposition, sputtering or the like. In the case where emission from the emitting layer is outcoupled through the cathode, the transmittance of the cathode is preferably more than 10%. The sheet resistance of the cathode is preferably several hundreds Ω/□ or less. The film thickness of the cathode, which is varied depending upon the material thereof, is usually from 10 nm to 1 μm, preferably from 50 to 200 nm.

It is preferable that at least one of the anode and the cathode be formed of a transparent or translucent substance in order to efficiently outcouple light from the emitting layer.

The method of fabricating the organic EL device according to the invention is not particularly limited. The organic EL device according to the invention may be fabricated using a known fabrication method used for an organic EL device.

EXAMPLES

The invention will be further explained with reference to the examples and the comparative examples shown below.

Example 1

A glass substrate, 25 mm x 75 mm x 1.1 mm thick, having ITO transparent electrode lines (manufactured by Geomatics Co.) was subjected to ultrasonic cleaning in isopropyl alcohol for 5 minutes and then to UV ozone cleaning for 30 minutes. The cleaned glass substrate having transparent electrode lines was set up on a substrate holder in a vacuum deposition device. First, a 100 nm thick film of N,N'-bis(N,N'-diphenyl-4-aminophenyl)-N,N-diphenyl-4,4'-diamino-1, 1' -biphenyl (hereinafter referred to as TPD 232 film) was formed by resistance heating deposition on the surface where the transparent electrode lines were formed, so as to cover the transparent electrode. The TPD 232 film functioned as a first hole-injecting (hole-transporting) layer. After the formation of the TPD 232 film, a 10 nm thick hole-transporting layer made of a compound HTM shown in the formula shown below was formed by resistance heating deposition. After the formation of the hole-transporting layer, a host compound (Compound No. Host 1 shown in Table 1; $Eg^T$ (Host) : 2.83 eV; Ip: 5.65 eV, Eg: 3.12 eV; represented by the formula shown below) and FIrpic ($Eg^T$ (Dopant): 2.76 eV; represented by the formula shown below) were co-deposited by resistance heating to form a 30 nm thick film thereon. The concentration of FIrpic was 7.5 mass%. This host compound: FIrpic film functioned as an emitting layer. After the formation of the emitting layer, an Alq (8-hydroxyquinolinol aluminum complex; $Eg^T$ (ETL)=2.00 eV; Ip: 5.70 eV, Eg: 2.70 eV) film with a certain thickness (30 nm) was formed by resistance heating deposition on the emitting layer. The Alq film functioned as an electron-transporting layer. Next, a 0.1 nm thick electron-injecting electrode (cathode) was formed from LiF at a film-formation rate of 1 Å/minute. A metal Al was deposited on the LiF layer to form a 130 nm thick metal cathode, thereby fabricating an organic EL device.

The ionization potential Ip of the materials was measured in an atmosphere with an ultraviolet photoelectron spectrometer AC-1 (Riken Keiki Co. , Ltd.). The optical energy gap Eg of the materials was obtained from measurement results of absorption spectrum of a toluene dilute solution of a material. The electron affinity Af of the materials was obtained using the formula shown below.

$$Af = Ip - Eg$$

The triplet energy gap $Eg^T$ of the materials was measured according to the method written in "The World of Photochemistry" mentioned above. Specifically, an organic material was dissolved in a solvent (a sample 10 μmol/L EPA (diethyl ether : isopentane : ethanol = 5 : 5 : 2 at a volume ratio)) to obtain a sample for a phosphorescence measurement. The sample was put in a quartz cell and cooled to 77 K. Exciting light was irradiated to measure emitted phosphorescence for wavelength. The tangent line was drawn to the rise on the short-wavelength side of the phosphorescent spectrum obtained. The wavelength value was converted to energy, which was a triplet energy gap value ($Eg^T$). A commercially available device F-4500 (Hitachi, Ltd.) was used for the measurement.

A difference ΔAf in electron affinity between a main organic material forming the emitting layer and a main material forming the electron-transporting layer was obtained by the formula shown below.

$$\Delta AF = Af\ (\text{electron-transporting layer}) - Af\ (\text{emitting layer})$$

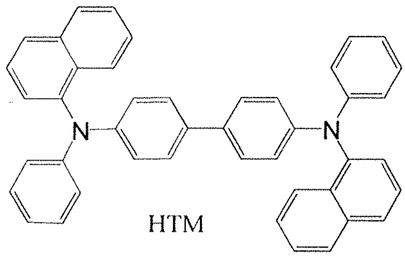

HTM

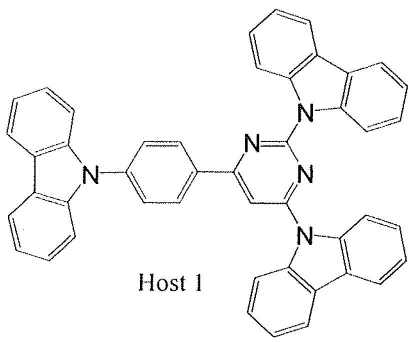

Host 1

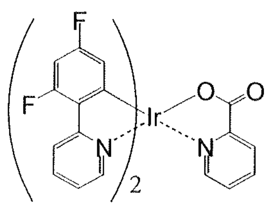

FIrpic

(Evaluation of organic EL device)

A luminance, current density and chromaticity (CIE) of the organic EL device obtained in Example 1 were measured under the conditions of applying a certain DC voltage shown in Table 1 to calculate a current efficiency (= (luminance)/(current density)) at an emission luminance of 100 cd/$m^2$. The results were shown in Table 1.

Example 2 and Comparative example 1

An organic EL device was fabricated and evaluated in the same manner as in Example 1 except that the host compound of the emitting layer was changed to the compound Host 2 (shown in the formula below) in Example 2.
An organic EL device was fabricated and evaluated in the same manner as in Example 1 except that the electron-transporting material was changed to the compound PC-7 (shown in the formula shown below) in Comparative example 1. The results were shown in Table 1.

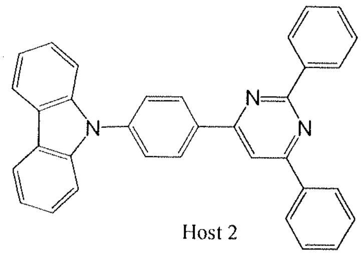

Host 2

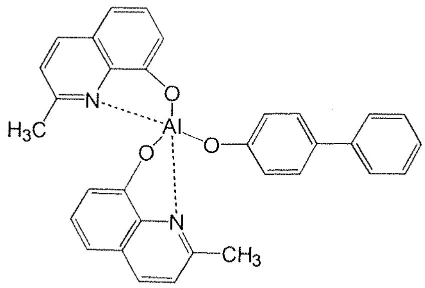

PC-7

Example 3 and Comparative example 2

An organic EL device was fabricated and evaluated in the same manner as in Example 1 except that the heavy metal organic complex FIrpic was changed to Ir(ppy) (EgT(Dopant) : 2.60 eV; shown in the formula shown below) in Example 3.
An organic EL device was fabricated and evaluated in the same manner as in Example 1 except that the heavy metal organic complex FIrpic was changed to Ir(ppy), the host compound of the emitting layer was changed to Host 2 and the electron-transporting material was changed to BCP (shown in the formula below) in Comparative example 2.
The results were shown in Table 1.
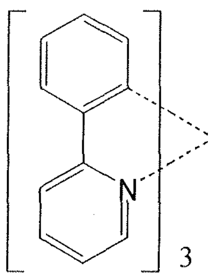

Ir(ppy)

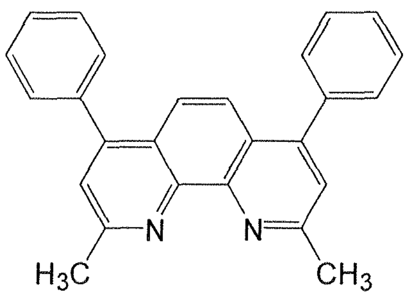

BCP

Example 4

An organic EL device was fabricated in the same manner as in Example 3 and evaluated in the same manner as in Example 1 except that the host compound of the emitting layer was changed to the compound Host 3 (shown in the formula below). The results were shown in Table 1.
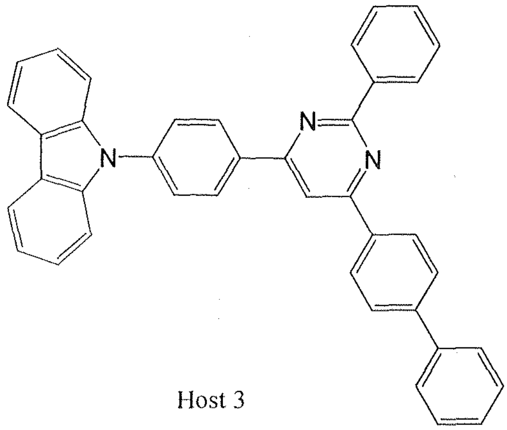

Host 3

Example 5

A hole-injecting layer and a hole-transporting layer were not formed, and a 100 nm thick emitting layer was formed directly on a substrate in the production process mentioned in Example 1. Further, a 30 nm thick Alq ($Eg^T$(ETL) < 2.7 eV) film was formed by resistance heating deposition on the emitting layer. The Alq film functioned as an electron-transporting layer. A 0.1 nm thick LiF film was then formed at a film-formation rate of 1 Å/minute as an electron-injecting electrode (cathode). On the LiF layer, a metal Al was deposited to form a 10 nm thick metal cathode and fabricated an organic EL device. The organic EL device obtained was evaluated in the same manner as in Example 1. The results were shown in Table 1.

Example 6

An amorphous SiC (p type semiconductive film) was formed on the ITO by plasma CVD technique in Example 5. It functioned as an inorganic hole-injecting and transporting layer. $SiH_4$ diluted with $H_2$ gas by 10%, $CH_4$ and 500 ppm-diluted $B_2H_4$ filled a chamber through a mass controller to a pressure of 1 Torr. At that time, the gas flow rate of $B_2H_4$ / ($SiH_4$ + $CH_4$) was 0.31%, a high frequency wave of 50 W and 13.56 MHz was applied and the substrate temperature was 190°C, under which conditions a 15 nm thick film was formed. Organic films, LiF film and Al film were formed in sequence thereon in the same steps as in Example 5 to fabricate an organic EL device. The organic EL device obtained was evaluated in the same manner as in Example 1. The results were shown in Table 1.

Table 1

| | | Unit | Example 1 | Example 2 | Example 3 | Example 4 | Example 5 | Example 6 | Com. Example 1 | Com. Example 2 |
|---|---|---|---|---|---|---|---|---|---|---|
| Emitting layer | Host compound | — | Host 1 | Host 2 | Host 1 | Host 3 | Host 1 | Host 1 | Host 1 | Host 2 |
| | $Eg^T$(Host) | eV | 2.83 | 2.82 | 2.83 | 2.72 | 2.83 | 2.83 | 2.83 | 2.82 |
| | Ionization potential Ip | eV | 5.65 | 5.60 | 5.65 | 5.91 | 5.65 | 5.65 | 5.65 | 5.60 |
| | Eg(Host) | eV | 3.12 | 3.25 | 3.12 | 3.25 | 3.12 | 3.12 | 3.12 | 3.25 |
| | Electron affinity Af | eV | 2.53 | 2.35 | 2.53 | 2.36 | 2.53 | 2.53 | 2.53 | 2.35 |
| | Dopant | — | FIrpic | FIrpic | Ir(ppy) | Ir(ppy) | FIrpic | FIrpic | FIrpic | Ir(ppy) |
| | $Eg^T$(Dopant) | eV | 2.76 | 2.76 | 2.60 | 2.60 | 2.76 | 2.76 | 2.76 | 2.60 |
| Elecrton-transporting layer | Material | — | Alq | Alq | Alq | Alq | Alq | Alq | PC-7 | BCP |
| | $Eg^T$(ETL) | eV | 2.00 | 2.00 | 2.00 | 2.00 | 2.00 | 2.00 | 2.20 | 2.60 |
| | Ionization potential Ip | eV | 5.70 | 5.70 | 5.70 | 5.70 | 5.70 | 5.70 | 5.70 | 6.60 |
| | Eg(ETL) | eV | 2.70 | 2.70 | 2.70 | 2.70 | 2.70 | 2.70 | 3.00 | 3.55 |
| | Electron affinity Af | eV | 3.00 | 3.00 | 3.00 | 3.00 | 3.00 | 3.00 | 2.70 | 3.05 |
| Defference of electron affinity ΔAf | | eV | 0.47 | 0.65 | 0.47 | 0.64 | 0.47 | 0.47 | 0.17 | 0.70 |
| Voltage | | V | 6.8 | 10.0 | 8.0 | 8.5 | 10.0 | 11.0 | 10.3 | 11.0 |
| Current density | | $mA/cm^2$ | 0.40 | 1.10 | 0.20 | 0.20 | 0.20 | 0.23 | 33.00 | 0.33 |
| CIE-chromaticity (x, y) | | — | (0.21, 0.41) | (0.21, 0.41) | (0.315,0.617) | (0.315, 0.617) | (0.21, 0.41) | (0.21, 0.41) | (0.21, 0.41) | (0.315,0.617) |
| Current efficiency | | cd/A | 17.2 | 10.1 | 50 | 50 | 50 | 45 | 0.3 | 30 |

In Table 1, Examples 1, 2, 5 and 6 are compared with Comparative example 1, and Examples 3 and 4 are compared with Comparative example 2, the emission colors thereof being the same. The current efficiencies of Examples 1 to 6 where a difference ΔAf in electron affinity is in a range of $0.2 < \Delta AF \leq 0.65$ are higher than those of Comparative examples 1 and 2 where a difference ΔAf in electron affinity is out of the above range.
The invention realizes an organic EL device with a higher current efficiency than conventional organic EL devices which have the same emission color. In Table 1, CIE - chromaticity (0.21, 0.41) shows greenish blue to green, and (0.315, 0.617) shows yellowish green.

Example 7

A device was fabricated except that CFIrpic ($Eg^T$(Dopant) : 2.70 eV; shown in the formula shown below) was used instead of Firpic in Example 1. The organic EL device obtained was evaluated in the same manner as in Example 1. The results are shown in Table 2.
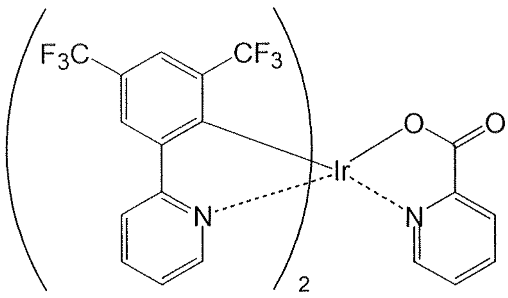

Example 8

The concentration in Example 7 was changed to 4 mass% to fabricate a device. The organic EL device obtained was evaluated in the same manner as in Example 1. The results were shown in Table 2.
Table 2

| | | Unit | Example 7 | Example 8 |
|---|---|---|---|---|
| Emitting layer | Host compound | — | Host 1 | Host 1 |
| | $Eg^T$(Host) | eV | 2.83 | 2.83 |
| | Ionization potential Ip | eV | 5.65 | 5.65 |
| | Eg(Host) | eV | 3.12 | 3.12 |
| | Electron affinity Af | eV | 2.53 | 2.53 |
| | Dopant | — | CFIrpic | CFIrpic |
| | $Eg^T$ (Dopant) | eV | 2.70 | 2.70 |
| Electron-transporting layer | Material | — | Alq | Alq |
| | $Eg^T$(ETL) | eV | 2.00 | 2.00 |
| | Ionization potential Ip | eV | 5.70 | 5.70 |
| | Eg (ETL) | eV | 2.70 | 2.70 |
| | Electron affinity Af | eV | 3.00 | 3.00 |
| Difference of electron affinity ΔAf | | eV | 0.47 | 0.47 |

(continued)

| | Unit | Example 7 | Example 8 |
|---|---|---|---|
| Voltage | V | 7.5 | 7.0 |
| Current density | $mA/cm^2$ | 0.40 | 0.50 |
| CIE-chromaticity (x, y) | — | (0.21, 0.45) | (0.20, 0.38) |
| Current efficiency | cd/A | 25 | 20 |

The emission spectrums of Examples 1 and 8 are shown in Figures 2 and 3. Apparently from the comparison therebetween, emission at a shorter wavelength than in Example 1 was measured in Example 8, and there is an emission component other than a dopant in Example 8.

INDUSTRIAL APPLICABILITY

The organic EL device of the invention can be suitably used for an information display device, a display device for military purposes, a lighting and so on because the current efficiency thereof is high.
The organic EL device of the invention can be suitably used for a flat luminescent body for wall hanging TVs, a back lighting source for displays and so on because the current efficiency thereof is high.

## Claims

1. An organic electroluminescent device having a structure in which at least an emitting layer and an electron-transporting layer are stacked between an anode and a cathode, the emitting layer containing an organic metal complex having at least a heavy metal as a central metal,
wherein a difference (ΔAF) in electron affinity between a main organic material forming the emitting layer and a main material forming the electron-transporting layer satisfies the following expression; "$0.2\ eV < \Delta AF \leq 0.65\ eV$".

2. The organic electroluminescent device according to claim 1 which emits electroluminescence at a longer wavelength than the wavelength corresponding to the triplet energy gap ($Eg^T$(Dopant)) of the organic metal complex having a heavy metal as a central metal.

3. The organic electroluminescent device according to claim 2, wherein the electroluminescence at a longer wavelength than the wavelength corresponding to the triplet energy gap ($Eg^T$ (Dopant)) of the organic metal complex having a heavy metal as a central metal is a main component of electroluminescence emitted from the device.

4. The organic electroluminescent device according to claim 1, wherein the main organic material forming the emitting layer has an electron transporting property.

5. The organic electroluminescent device according to claim 1, wherein the triplet energy gap ($Eg^T$ (Host)) of the main organic material forming the emitting layer is 2.52 eV or more.

6. The organic electroluminescent device according to claim 1, wherein the triplet energy gap ($Eg^T$ (Dopant)) of the organic metal complex having a heavy metal as a central metal is equal to or greater than the triplet energy gap ($Eg^T$ (ETL)) of the main material forming the electron-transporting layer.

7. The organic electroluminescent device according to claim 1, wherein the triplet energy gap ($Eg^T$ (Host)) of the main organic material forming the emitting layer is equal to or greater the triplet energy gap ($Eg^T$ (Dopant)) of the organic metal complex having a heavy metal as a central metal.

FIG. 1

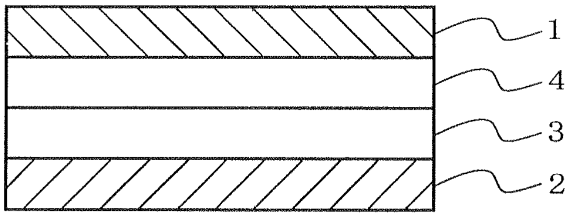


FIG. 2

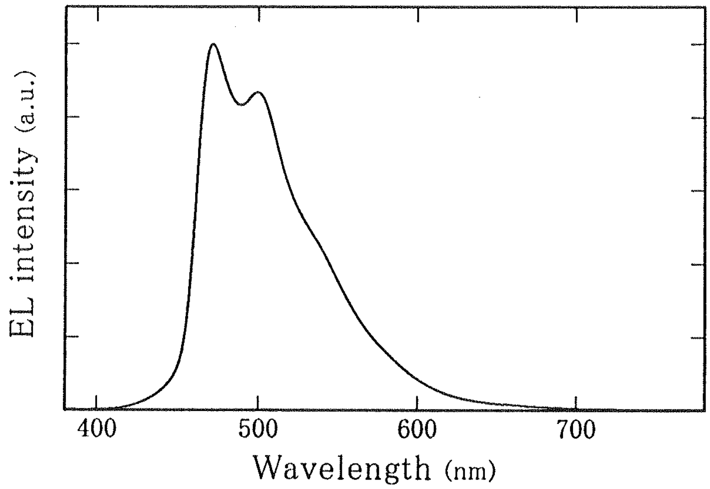


FIG. 3

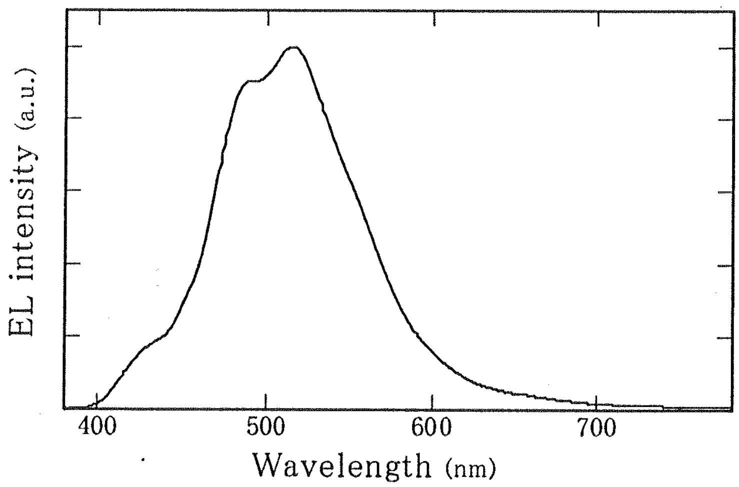

## INTERNATIONAL SEARCH REPORT

International application No.
PCT/JP2005/001584

A. CLASSIFICATION OF SUBJECT MATTER
Int.Cl[7] H05B33/14, 33/22

According to International Patent Classification (IPC) or to both national classification and IPC

B. FIELDS SEARCHED

Minimum documentation searched (classification system followed by classification symbols)
Int.Cl[7] H05B33/14, 33/22

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)
JICST FILE(JOIS)

C. DOCUMENTS CONSIDERED TO BE RELEVANT

| Category* | Citation of document, with indication, where appropriate, of the relevant passages | Relevant to claim No. |
|---|---|---|
| Y | Toray Research Center Inc., "Yuki EL Display no Honkaku Jitsuyoka Saizensen", Dai 1 Satsu, 15 June, 2002 (15.06.02), pages 262 to 265 | 1-7 |
| A | JP 2000-164359 A (Idemitsu Kosan Co., Ltd.), 16 June, 2000 (16.06.00), Par. No. [0026] (Family: none) | 1 |
| A | JP 2003-347064 A (Matsushita Electric Works, Ltd.), 05 December, 2003 (05.12.03), Par. Nos. [0006] to [0007], [0025] to [0026] (Family: none) | 1 |

☒ Further documents are listed in the continuation of Box C.   ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>14 April, 2005 (14.04.05) | Date of mailing of the international search report<br>10 May, 2005 (10.05.05) |
| Name and mailing address of the ISA/<br>Japanese Patent Office<br>Facsimile No. | Authorized officer<br><br>Telephone No. |

Form PCT/ISA/210 (second sheet) (January 2004)

**INTERNATIONAL SEARCH REPORT**

International application No.
PCT/JP2005/001584

C (Continuation). DOCUMENTS CONSIDERED TO BE RELEVANT

| Category* | Citation of document, with indication, where appropriate, of the relevant passages | Relevant to claim No. |
|---|---|---|
| A | Hideyuki MURATA, "Dai 6 Sho Host-Guest-Kei Hakkoso ni yoru Soshi no Kokoritsuka, Yuki EL Zairyo to Display", Dai 2 Satsu, 20 April, 2001 (20.04.01), page 99 | 1-7 |
| A | JP 2002-203683 A (Toyota Central Research And Development Laboratories, Inc.), 19 July, 2002 (19.07.02), Par. Nos. [0008], [0049] & EP 1202608 A2 | 1,3-5,7 |
| A | JP 2003-317966 A (Canon Inc.), 07 November, 2003 (07.11.03), Full text (Family: none) | 2,3-5,7 |
| A | JP 2002-100476 A (Fuji Photo Film Co., Ltd.), 05 April, 2002 (05.04.02), Par. Nos. [0006] to [0013], [0164] to [0209] (Family: none) | 2,3,5-7 |
| A | JP 2003-288988 A (Matsushita Electric Industrial Co., Ltd.), 10 October, 2003 (10.10.03), Par. Nos. [0057] to [0095] (Family: none) | 1-7 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 63295695 A


### Non-patent literature cited in the description


- **TSUTSUI et al.** *Japanese Journal of Applied Physics,* 1999, vol. 38, 1502-1504
- The World of Photochemistry. Chemical Society of Japan, 1993, 50